# EUROPÄISCHE PATENTANMELDUNG

(11) **EP 1 253 428 A2**
(43) Veröffentlichungstag der Anmeldung: **30.10.2002**
(21) Anmeldenummer: 02009084.1
(22) Anmeldetag: 24.04.2002
(51) Int. Cl.: G01R 17/16, G01L 1/22, G01D 5/16

(54) **Messbrückenschaltung in Vier- oder Mehrleitertechnik mit Ausregelung der Leitungsverluste**

(30) Priorität: 28.04.2001 DE 10120983
(71) Anmelder: Hottinger Baldwin Messtechnik GmbH, 64293 Darmstadt (DE)
(72) Erfinder: Seidenstücker, Dieter, 64293 Darmstadt (DE); Kreuzer, Manfred, 64331 Weiterstadt (DE)
(74) Vertreter: Behrens, Helmut, Dipl.-Ing.

(57) **Zusammenfassung**

Die Erfindung betrifft eine Meßbrückenschaltung in Vier- oder Mehrleitertechnik, die aus mindestens einem Dehnungsmeßstreifen besteht, der über mindestens vier Anschlußleitungen mit einer Meßverstärkerschaltung (3) und einer internen Halbbrücke (5) verbunden ist. Zwischen einer Speiseleitung (2) und einer Fühlerleitung (2') ist ein Kompensationsverstärker (V1) zur Ausregelung des Spannungsabfalls auf der ersten Speiseleitung vorgesehen. Zwischen die zweite Speiseleitung (4) und einer Meßleitung (4') ist ein Differenzverstärker (V4) geschaltet, der den Spannungsabfall auf der zweiten Speiseleitung der internen Ergänzungsviertelbrücke zuschlägt. Dazu wird die Ausgangsspannung des Differenzverstärkers (V4) einer Additionsschaltung (V5) zugeführt, die den Spannungsabfall auf der zweiten Speiseleitung (4) um den konstanten Anteil an der Ergänzungsviertelbrücke (8) erhöht. Dadurch ist jeder Leitungsspannungsabfall separat ausregelbar, ohne daß dies Einfluß auf den Nullpunkt der Meßbrücke hat. Dadurch ist gleichzeitig eine konstante Brückenspeisespannung einsetzbar, die fest an die Ergänzungshalbbrücke (8) anlegbar ist und somit auch global für andere Meßverstärkerschaltungen mitbenutzt werden kann.

## Beschreibung

Die Erfindung betrifft eine Meßbrückenschaltung in Vier- oder Mehrleitertechnik gemäß dem Oberbegriff des Patentanspruchs 1.

Beim Einsatz von Dehnungsmeßstreifen zur Meßwerterfassung werden diese meist mit Kompensationsdehnungsmeßstreifen oder Ergänzungswiderständen zu einer Wheatstone'schen-Brücke verschaltet. Insbesondere wenn Einzeldehnungsmeßstreifen über längere Leitungswege mit den übrigen Brückenzweigen zu einer sogenannten 1/4-Brücke verbunden werden, können die Leitungswiderstände zu Spannungsabfällen führen, die die Meßgenauigkeit erheblich beeinträchtigen. Dabei hängen die Spannungsabfälle im wesentlichen von den Leitungslängen und Querschnitten zwischen den Dehnungsmeßstreifen und den übrigen Ergänzungswiderständen und auch von den Umgebungstemperaturen ab. Bei Meßaufgaben, bei denen es nicht möglich oder sinnvoll ist, die Dehnungsmeßstreifen in der Nähe der Brückenergänzung anzuordnen, kann der Einfluß dieser Spannungsabfälle durch schaltungstechnische Maßnahmen minimiert werden.

Aus dem Rohrbach, Handbuch für experimentelle Spannungsanalyse, Düsseldorf 1989, Seiten 674 bis 676 ist eine Viertel-Brücke in sogenannter Dreileitertechnik vorbekannt, durch die derartige Spannungsabfälle in den Anschlußleitungen meßtechnisch berücksichtigt werden. Dazu wird der Dehnungsmeßstreifen über zwei Zuleitungen mit den Ergänzungswiderständen und der Speisespannungsquelle verbunden. Über eine dritte Anschlußleitung wird in die Meßdiagonale der Brücke ein Operationsverstärker geschaltet, so daß dadurch die beiden Spannungsabfälle in verschiedenen Brückenzweigen wirksam werden und sich bei gleicher Größe kompensieren. Hierdurch werden zwar die Nullpunktfehler vermieden, aber der Einfluß auf die Empfindlichkeit kann damit nicht beseitigt werden.

Aus dem Rohrbach, Handbuch für experimentelle Spannungsanalyse, Seite 676 ist eine sogenannte Vierleiterschaltung vorbekannt, mit der eine derartige Empfindlichkeitsminderung vermieden wird. Dazu ist ein in Viertelbrückenschaltung befindlicher Dehnungsmeßstreifen über vier Zuleitungen mit den übrigen Brückenelementen verbunden, wobei der Spannungsabfall auf der einen Speiseleitung durch einen Operationsverstärker zwischen der Speiseleitung und einer Fühlerleitung ausgeglichen wird. Weiterhin sind zwischen einer weiteren Speiseleitung und einer Meßleitung noch zwei Operationsverstärker vorgesehen, die den Spannungsabfall auf der zweiten Speiseleitung durch eine zusätzliche interne Halbbrücke symmetrisch auf die beiden Brükkenzweige verteilen und die Speisespannung um den Spannungsabfall auf dieser Speiseleitung entsprechend erhöhen, so daß auch die Empfindlichkeitseinbuße vermieden wird. Allerdings gibt es häufig Anwendungsfälle, bei denen sehr große Meßstellenzahlen vorkommen, wie z. B. bei der Strukturanalyse von Flugzeugteilen, wo der Bauteileaufwand durch die Speisespannungsnachregelung in jedem Verstärkerkanal groß wird.

Der Erfindung liegt deshalb die Aufgabe zugrunde, eine Meßbrückenschaltung mit Einzeldehnungsmeßstreifen zu schaffen, durch die auch längere Anschlußleitungen kompensierbar sind und dies bei geringstem Aufwand.

Diese Aufgabe wird durch die im Patentanspruch 1 angegebene Erfindung gelöst. Weiterbildungen und vorteilhafte Ausführungsbeispiele sind in den Unteransprüchen angegeben.

Die Erfindung hat den Vorteil, daß die Brückenversorgung und die interne Halbbrücke außerhalb des Regelkreises vorgesehen sind. Dies ermöglicht bei mehrkanalig ausgeführten Meßverstärkern nur eine globale Brückenspeisung und nur eine interne Halbbrücke auszuführen, welche von allen Meßkanälen einer Verstärkerbaugruppe genutzt werden können. Insbesondere bei der Vielkanalmeßtechnik wird dadurch der Schaltungsaufwand und der dafür notwendige Platzbedarf erheblich verringert.

Die Erfindung hat weiterhin den Vorteil, daß der Spannungsverlust durch die Speiseleitungswiderstände jedem zugehörigen Viertelbrückenzweig zugeschlagen und dort auch ausgeregelt wird. Dadurch wird eine gegenseitige Beeinflussung der Ausregelung der Leitungswiderstände verhindert, so daß insbesondere bei der Vielstellenmeßtechnik einer der Anschlüsse aller Dehnungsmeßstreifen zu einer gemeinsamen Leitung zusammengeführt und separat ausgeregelt werden kann, wodurch der Leitungsaufwand erheblich reduzierbar ist.

Eine besondere Ausführung der Erfindung hat den Vorteil, daß an die vereinfachte Meßbrückenschaltung sowohl der Anschluß von Dehnungsmeßstreifen in Viertel-, Halb- und Vollbrückenschaltungen ermöglicht wird, wobei lediglich einfache Umschaltelemente zur Anpassung vorzusehen sind. Dabei hat die Schaltung zusätzlich noch den Vorteil, daß nicht nur die Leitungswiderstände, sondern gleichzeitig auch die Schaltwiderstände der Umschaltelemente ausgeglichen werden, ohne daß ein zusätzlicher Schaltungsaufwand erforderlich ist.

Die Erfindung wird anhand eines Ausführungsbeispiels, das in der Zeichnung dargestellt ist, näher erläutert. Es zeigen:
- Fig. 1:: eine ¼-Brückenschaltung in Vierleitertechnik mit Ausregelung der Leitungseinflüsse im Dehnungsmeßstreifen- und Ergänzungsviertelbrückenzweig;
- Fig. 2:: eine Meßbrückenschaltung in Vierleitertechnik mit Ausregelung der Leitungseinflüsse nur im Dehnungsmeßstreifenviertelbrückenzweig, und
- Fig. 3:: eine Mehrleitermeßbrückenschaltung mit umschaltbaren Brückenelementen.

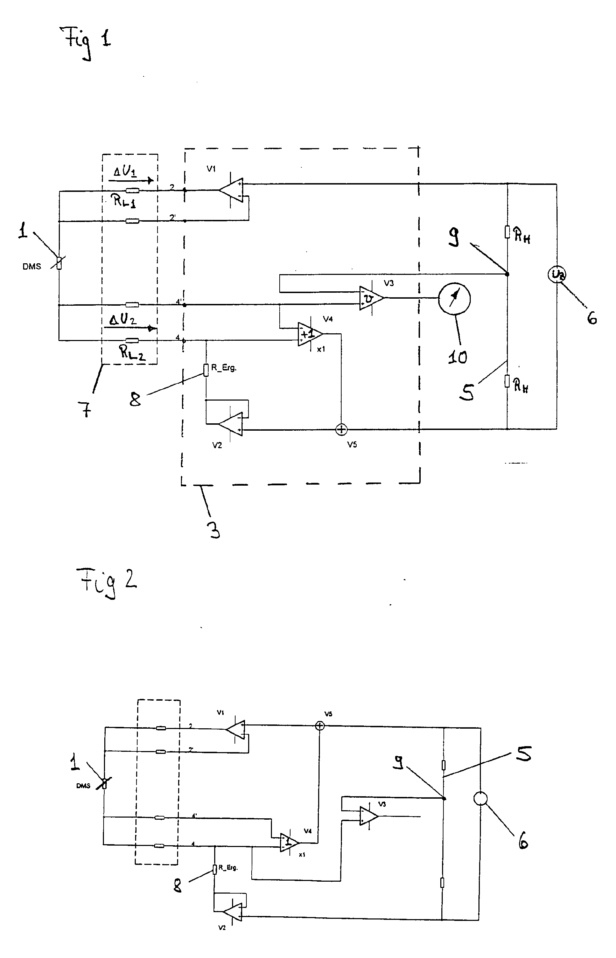

In Fig. 1 der Zeichnung ist eine Meßbrückenschaltung mit einem Dehnungsmeßstreifen 1 in ¼-Brückenschaltung dargestellt, der über vier Anschlußleitungen 7 mit den weiter entfernt angeordneten Brückenzweigen in einer Meßverstärkerschaltung 3 verbunden ist, an die eine interne Halbbrücke 5 und eine Speisespannungsversorgung 6 angeschlossen ist.

Die Brückenschaltung besteht im wesentlichen aus einem Dehnungsmeßstreifen 1, der als veränderbarer Widerstand dargestellt ist. Dieser Dehnungsmeßstreifen 1 ist an einem nicht dargestellten zu messenden Bauteil befestigt. Dabei wird in der Regel die Dehnung dieses belasteten Bauteils in einem Versuchsaufbau gemessen. In der Praxis können deshalb einige tausend dieser Dehnungsmeßstreifen 1 an dem zu untersuchenden Bauteil angebracht sein, die dann mit den weiter entfernt angeordneten Meßverstärkerschaltungen 3 verbunden sind. Jeder Dehnungsmeßstreifen 1 ist zur Erfassung der Dehnung als ¼-Brücke geschaltet und über zwei Anschlußpunkte mit den vier Anschlußleitungen 7 mit der übrigen Meßbrückenschaltung 3, 5, 6, 10 verbunden. Dabei können die Anschlußleitungen auch bis zu einigen hundert Metern Länge betragen und sind deshalb aus Kosten- und Platzgründen meist aus dünnen Kupferleitungen gefertigt. Da zwei Anschlußleitungen 2, 4 zur Speisung des Dehnungsmeßstreifens 1 dienen, verursachen diese Kupferleitungen durch ihre Leitungswiderstände R_{L1} und R_{L2} die Spannungsabfälle ΔU₁ und ΔU₂. Diese beiden Anschlußleitungen 2, 4 sind mit der Meßverstärkerschaltung 3 verbunden, die im wesentlichen aus der Ergänzung des Viertelbrückenzweiges und der Speisespannungsnachregelung besteht.

Der Dehnungsmeßstreifen 1 ist mit einer ersten Speiseleitung 2 mit dem Ausgang eines ersten Kompensationsverstärkers V1 verbunden, der mit seinem hochohmigen Minuseingang mit einer Fühlerleitung 2' beschaltet ist. Der andere Verstärkereingang ist mit der Speisespannungsquelle 6 verbunden, so daß der Kompensationsverstärker V1 den Speisespannungsabfall ΔU₁ auf der Speiseleitung 2 zum Dehnungsmeßstreifen 1 ausregelt.

Eine zweite Speiseleitung 4 des Dehnungsmeßstreifen 1 ist zum einen mit dem Ergänzungswiderstand 8 verbunden, der die Viertelbrücke des Dehnungsmeßstreifens 1 zu einer Halbbrücke ergänzt. Die zweite Speiseleitung 4 ist andererseits noch mit dem hochohmigen Eingang eines Differenzverstärkers V4 verbunden, der mit seinem Minuseingang an einer Meßleitung 4' anliegt. Am Differenzverstärker V4 liegt damit der Speisespannungsabfall ΔU₂ auf der zweiten Speiseleitung 4 an. Der Differenzverstärker V4 hat die Verstärkung 1. Der Ausgang des Differenzverstärkers V4 ist mit einer Additionsschaltung verbunden, die als Summierverstärker V5 ausgebildet ist. Am Summierverstärker V5 liegt gleichzeitig die Speisespannungsquelle 6 und der positive Eingang eines zweiten Kompensationsverstärkers V2 an, dessen Ausgang mit dem Ergänzungswiderstand 8 verbunden ist. Weiterhin ist der Minuseingang des zweiten Kompensationsverstärkers V2 auf den Ausgang zurückgekoppelt. Dadurch wird der durch den Differenzverstärker V4 erfaßte Speisespannungsabfall ΔU₂ der Spannung am Ergänzungswiderstand 8 zugeschlagen und um diesen die Spannung am Ergänzungswiderstand 8 erhöht. Da der Speisespannungsabfall ΔU₂ dem Ergänzungswiderstand 8 zugeschlagen wird, entsteht keine Nullpunktabweichung im Diagonalmeßzweig der Vollbrücke, so daß der Meßwert durch den Verstärker V3 direkt im Diagonalzweig erfaßt und verstärkt werden kann.

Der Diagonalmeßzweig wird durch den Mittelabgriff zwischen dem Dehnungsmeßstreifen 1 und dem Ergänzungswiderstand 8 an der Meßleitung 4', sowie dem Mittelabgriff 9 an der internen Halbbrücke 5 mit den beiden gleichartigen Hilfswiderständen R_{H} gebildet, die mit den beiden Viertelbrücken aus den Dehnungsmeßstreifen 1 und dem Ergänzungswiderstand 8 eine Wheatstone'sche Vollbrücke darstellt. Da die Speisespannung durch die Nullpunktstabilität im Diagonalzweig nicht symmetrisch nachgeregelt werden muß, kann die interne Halbbrücke 5 direkt an eine konstante Brückenspannung gelegt werden. Die interne Halbbrükke 5 und die Speisespannung können außerhalb des jeweiligen Verstärkerkanals 3 angeordnet sein. Dadurch kann auch die Brückenspannungsquelle 6 und die interne Halbbrücke 5 noch von weiteren Meßverstärkerschaltungen 3 anderer Meßkanäle genutzt werden, wodurch bei einer Vielstellenmeßverstärkergruppe erhebliche Bauelemente und Bestückungsraum einzusparen sind. Der direkt im Diagonalzweig 4', 9 angeordnete Meßverstärker V3 erfaßt und verstärkt dabei unmittelbar die Dehnung oder einen davon abgeleiteten Meßwert am Dehnungsmeßstreifen 1, der in einer Anzeigevorrichtung 10 anzeigbar und/oder in einer nicht dargestellten Auswertevorrichtung weiterverarbeitbar ist.

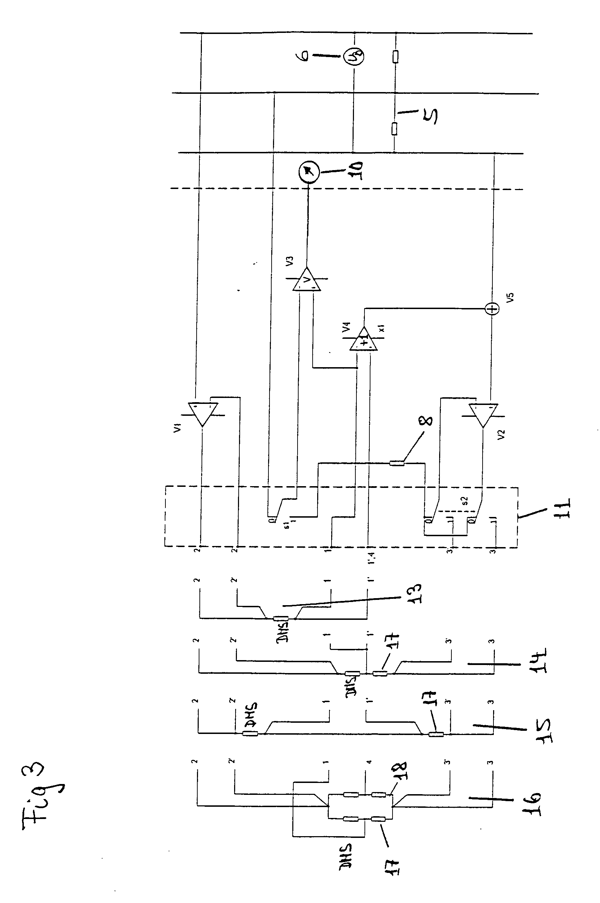

Die Fig. 2 der Zeichnung stellt eine Vierleiter-Meßbrückenschaltung dar, bei der die Spannungsnachregelung durch den Differenzverstärker V4 der Dehnungsmeßstreifenviertelbrücke zugeschlagen wird. Die Meßbrückenschaltung nach Fig. 2 entspricht deshalb im wesentlichen auch der Schaltung nach Fig. 1 der Zeichnung. Die Fig. 2 unterscheidet sich dadurch, daß die Addierschaltung V5 im Viertelbrückenzweig des Dehnungsmeßstreifens zwischen dem ersten Kompensationsverstärkereingang V1 und der internen Halbbrücke 5 bzw. der Speisespannungsquelle 6 angeordnet ist. Außerdem ist die Meßdiagonale jetzt zwischen der Speiseleitung 4 am Ergänzungswiderstand 8 und dem Mittelabgriff 9 der internen Halbbrücke 5. Dadurch wird der gesamte Leitungsspannungsabfall ΔU₁ und ΔU₂ auf der ersten Speiseleitung 2 vollständig ausgeregelt, ohne daß dies einen Einfluß auf den Nullpunkt und die Empfindlichkeit der gesamten Meßbrückenschaltung hat.

In Fig. 3 der Zeichnung ist eine Vier- bis Sechsleitermeßbrükkenschaltung dargestellt, an die verschiedene externe Meßbrükkenelemente anschließbar sind. Diese Schaltung zeigt vier verschiedene externe Meßbrückenelemente, die über ein Konfigurationsfeld 11 an die Meßverstärkerschaltung 12 angeschlossen werden können. Dabei besteht die Meßverstärkerschaltung 12 aus der gleichen Schaltung wie nach Fig. 1 der Zeichnung, die auch mit einer globalen Halbbrücke 5 und Spannungsversorgung 6 verbunden ist.

In dem Konfigurationsfeld 11 sind zusätzliche Schaltelemente S1 und S2 vorgesehen, durch die die interne Halbbrücke 5 und der interne Ergänzungswiderstand 8 abschaltbar sind und durch extern am Meßobjekt befindliche Ergänzungswiderstände, Kompensationswiderstände und Halbbrücken ersetzt werden. So können an einen serienmäßig herstellbaren Verstärkerkanal 12 nicht nur Dehnungsmeßstreifen 1 in Viertelbrückenschaltung, sondern auch solche mit speziellen Ergänzungs- oder Kompensationswiderständen oder ganze Vollbrücken geschaltet werden. Deshalb sind zusätzlich zu den vorgesehenen zwei Meß- und Speiseleitungen 2; 1' und zwei Fühlerleitungen 2', 1 noch eine oder zwei zusätzliche Speise- und Fühlerleitungen 3, 3' notwendig, um die extern am Meßobjekt befindlichen Brückenelemente über das Konfigurationsfeld 11 an die Meßverstärkerschaltung 12 anzuschließen.

Dabei arbeitet die vorgesehene Viertelbrücke 13 mit dem Dehnungsmeßstreifen nach dem ersten Anschaltbeispiel wie die Schaltung nach Fig. 1 der Zeichnung, bei der die Schaltelemente S1, S2 in der dargestellten Stellung des Konfigurationsfeldes 11 verbleiben.

Bei dem zweiten Anschaltbeispiel 14 ist lediglich der Ergänzungswiderstand 8 außerhalb der Meßverstärkerschaltung 12 gelegt, was beispielsweise notwendig ist, wenn wegen größerer Temperaturschwankungen der Ergänzungswiderstand 17 als Kompensationswiderstand am Meßobjekt positioniert werden soll. Weiterhin ist bei höheren Meßgenauigkeitsanforderungen der Ergänzungswiderstand als gegenläufig positionierter Dehnungsmeßstreifen geschaltet, der dann auch am Meßobjekt positioniert werden muß. Bei diesem Anschaltbeispiel 14 wird auch das Schaltelement S2 betätigt, das den internen Ergänzungswiderstand 8 auf einen externen Brückenwiderstand 17 umschaltet.

Beim dritten Anschaltbeispiel 15 ist schaltungstechnisch der gleiche Fall wie beim zweiten Anschaltbeispiel 14 vorgesehen, nur daß der Ergänzungswiderstand 17 und der meßwerterfassende Dehnungsmeßstreifen räumlich voneinander entfernt angeordnet sind, so daß zwei Fühlerleitungen 1, 1' zu der Meßstelle und dem Ergänzungswiderstand 17 notwendig sind, die den Spannungsabfall zwischen den beiden Widerständen DMS, 17 berücksichtigen. Dies dritte Schaltungsbeispiel 15 wird beispielsweise dann gewählt, wenn der Nennwert des Dehnungsmeßstreifens DMS von den Standardwerten abweicht, so daß auch ein spezifischer Ergänzungswiderstand 17 vorgesehen werden muß, der dann auch räumlich vom Meßobjekt entfernt angeordnet sein kann.

Beim vierten Anschaltbeispiel 16 ist die Anschaltung einer Vollbrücke an die Meßverstärkerschaltung 12 vorgesehen, bei der sowohl die globale Halbbrücke 5 als auch der interne Ergänzungswiderstand 8 durch die Schaltelemente S1 und S2 abgeschaltet werden müssen. In diesem Fall ist eine Sechsleiterschaltung zur Anschaltung an den Meßverstärker 12 notwendig, mit der auch alle meßwertverfälschenden Leitungs- und Schaltelementewiderstände ausregelbar sind, ohne daß dadurch auch die Meßempfindlichkeit verringert wird.

## Patentansprüche

1. Meßbrückenschaltung in Vier- oder Mehrleiterschaltung, die aus mindestens einem Dehnungsmeßstreifen bestehen, der über mindestens vier Anschlußleitungen mit einer Meßverstärkerschaltung und einer internen Halbbrücke verbunden ist, wobei zwischen einer ersten Speiseleitung (2) und einer Fühlerleitung (2') ein Kompensationsverstärker (V1) zur Ausregelung des Spannungsabfalls auf der ersten Speiseleitung vorgesehen ist und daß zwischen der zweiten Speiseleitung (4) und einer Meßleitung (4') ein Differenzverstärker (V4) geschaltet ist, **dadurch gekennzeichnet, daß** die Ausgangsspannung des Differenzverstärkers (V4) über eine Addierschaltung (V5) dem konstanten Speisespannungsanteil an einer Ergänzungsviertelbrücke (8) oder der Dehnungsmeßstreifenviertelbrücke (1) zugeschlagen wird.

2. Meßbrückenschaltung nach Anspruch 1, **dadurch gekennzeichnet, daß** zur Brückenspeisung eine konstante Speisespannungsquelle (6) vorgesehen ist, deren Spannung unmittelbar an der internen Halbbrücke (5) und am ersten oder zweiten Kompensationsverstärker (V1, V2) sowie der Addierschaltung (V5) anliegt.

3. Meßbrückenschaltung nach Anspruch 1 oder 2, **dadurch gekennzeichnet, daß** sowohl die interne Halbbrücke (5) als auch die Speisespannungsquelle (6) als globale Schaltungselemente vorgesehen sind, die auch mit weiteren Meßverstärkerschaltungen (3) verschaltet sind.

4. Meßbrückenschaltung nach einem der vorhergehenden Ansprüche, **dadurch gekennzeichnet, daß** die Verstärkerschaltung als hochohmiger Operationsverstärker (V3) ausgebildet ist, dessen Eingang unmittelbar an die Anschlußpunkte (4', 9) der Vollbrücke geschaltet ist und an dessen Ausgang ein Meßsignal anliegt, das der Meßgröße am Dehnungsmeßstreifen proportional ist.

5. Meßbrückenschaltung nach einem der vorhergehenden Ansprüche, **dadurch gekennzeichnet, daß** die Ergänzungsviertelbrücke aus dem Ergänzungswiderstand (8) besteht und in der Meßverstärkerschaltung (3) integriert ist und daß der Speisespannungsabfall durch Addition des konstanten Speisespannungsanteils am Ergänzungswiderstand (8) und der jeweiligen Ausgangsspannung am Differenzverstärker (V4) mit einer Verstärkung von v=1 über einen hochohmigen zweiten Kompensationsverstärker (V2) zugeführt wird.

6. Meßbrückenschaltung nach einem der vorhergehenden Ansprüche, **dadurch gekennzeichnet, daß** vor dem Eingangsbereich der Meßverstärkerschaltung (3) ein Konfigurationsfeld (11) vorgesehen ist, das Umschaltelemente (S1, S2) enthält, mit dessen Hilfe externe Brückenelemente (14, 15, 16) mit externen Ergänzungswiderständen (17) und externen Halbbrücken (18) anschaltbar sind, wodurch Schaltungen in Fünf- und/oder Sechsleitertechnik gebildet werden.
